# FASCICULE DE BREVET EUROPEEN

(11) **EP 4 672 925 B1**
(45) Date de publication et mention de la délivrance du brevet: **25.11.2026**
(21) Numéro de dépôt: 25183927.0
(22) Date de dépôt: 19.06.2025
(51) Int. Cl.: H10H 20/817, H10H 29/14, H10H 20/815

(54) **PROCEDE DE POROSIFICATION DE MESAS**
VERFAHREN ZUR PORENBILDUNG VON MESAS
METHOD FOR POROSIFICATION OF MESAS

(30) Priorité: 27.06.2024 FR 2406898
(43) Date de publication de la demande: 31.12.2025
(73) Titulaire: Commissariat à l'Energie Atomique et aux Energies Alternatives, 75015 Paris (FR)
(72) Inventeur: PERNEL, Carole, 38054 GRENOBE CEDEX 09 (FR); AUDIBERT, Margaux, 38054 GRENOBLE CEDEX 09 (FR); VIVARES, Valentin, 38054 GRENOBLE CEDEX 09 (FR)
(74) Mandataire: Cabinet Beaumont

(56) Documents cités:
- EP-A1- 4 383 359
- WO-A1-2022/029433

## Description

### Domaine technique

La présente description concerne de façon générale le domaine général des micro-écrans couleur à base de micro-LEDs.

L'invention concerne un procédé pour porosifier des mésas, par exemple des mésas (Al,In, Ga)N/(Al,In,Ga)N ou des mésas InP/InP.

L'invention concerne également une structure ainsi obtenue comprenant des mésas porosifiées.

### Technique antérieure

Les micro-écrans couleurs comprennent des pixels formés de sous-pixels bleus, verts et rouges (pixels RGB). Dans la suite de la description, ces sous-pixels seront désignés plus simplement pixel par souci de concision.

Les pixels bleus et verts peuvent être fabriqués à base de matériaux nitrures et les pixels rouges à base de matériaux phosphures. Pour combiner sur le même substrat ces trois types de pixels, la technique dite de « pick and place » est généralement utilisée. Cependant, dans le cas des micro-écrans avec des pixels inférieurs à 10 µm et/ou des écrans avec un grand nombre de pixels (définition élevée), cette technique ne peut plus être utilisée à cause des problèmes d'alignement et/ou du temps nécessaire pour la réaliser. De plus il faut prélever les pixels sur des plaques ('wafer') différentes, ce qui nécessite des transferts successifs. Des techniques de transfert en parallèle peuvent également utilisées ('mass transfert').

Une autre solution consiste à réaliser la conversion de couleurs avec des boîtes quantiques (QD pour « Quantum Dot » en langue anglaise) ou des nanophosphores pompés par des µLEDs bleues issues d'une seule plaque ('wafer'), soit reportés, soit dans une matrice monolithique (cas préféré pour les micro-écrans). Cependant, le contrôle du dépôt de ces matériaux sur des pixels de faibles dimensions est difficile et leur tenue au flux n'est pas suffisamment robuste.

Une solution consiste à former les trois pixels RGB de façon native avec la même famille de matériaux, afin de pouvoir réaliser leur croissance sur un même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'InN dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Actuellement, une des solutions les plus prometteuses consiste à porosifier la couche de GaN des mésas par voie électrochimique en appliquant un potentiel pendant une durée déterminée. La couche porosifiée de GaN ainsi obtenue peut permettre de faire croitre une structure LED nitrure à base d'InGaN de meilleure qualité cristalline, grâce à la relaxation des mésas poreux générés.

Cependant, il a été observé que les reprises d'épitaxie par dépôt chimique en phase vapeur à partir de précurseur métalorganiques (MOCVD) sur des mésas InGaN/GaN poreux semblent perturbées par la présence de porosité sur les flancs des mésas. Une couche de « liner » doit donc être déposée sur les flancs pour « neutraliser » la porosité et pour ne pas épitaxier sur les flancs. Cependant, lorsque le pas de pixellisation (« pitch ») diminue, ou que la distance inter-mésas diminue, le dépôt de la couche de liner est plus délicat. Les documents EP 4 383 359 A1 et WO 2022/029433 A1 décrivent des structures porosifiées et leurs procédés de porosification.

### Résumé de l'invention

Il existe un besoin d'avoir un procédé de fabrication d'un dispositif comprenant des mésas poreuses, une reprise d'épitaxie devant pouvoir être facilement réalisées sur les mésas obtenues.

Ce but est atteint par un procédé de porosification d'une structure comprenant un substrat de base recouvert de mésas, les mésas étant des mésas (Al,In,Ga)N ou InP ou des mésas (Al,In,Ga)N/(Al,In,Ga)N ou InP/InP, les mésas étant porosifiées par voie électrochimique selon le cycle d'étapes suivantes :
i) appliquer un premier potentiel pendant une première durée,
ii) appliquer un deuxième potentiel pendant une deuxième durée, moyennant quoi on obtient des mésas porosifiées comprenant, depuis les faces latérales des mésas vers le centre des mésas ou inversement, une première partie ayant un premier taux de porosification et une deuxième partie, la deuxième partie ayant un deuxième taux de porosification supérieur au premier taux de porosification ou la deuxième partie étant évidée.

Selon un mode de réalisation particulier, le premier potentiel est inférieur au deuxième potentiel.

Selon un mode de réalisation particulier, le premier potentiel est compris entre 3 V et 12 V et/ou le deuxième potentiel est compris entre 5 et 20 V.

Selon un mode de réalisation particulier, l'étape i) ou le cycle d'étapes i) et ii) est répété au moins une fois de manière à former une alternance de premières parties et de deuxièmes parties.

Ce but est également atteint par une structure comprenant un substrat de base recouvert de mésas porosifiées comme définie dans la revendication 5, les mésas porosifiées étant des mésas (Al,In,Ga)N ou InP ou des mésas (Al,In,Ga)N/(Al,In,Ga)N ou InP/InP, les mésas comprenant, depuis les faces latérales des mésas vers le centre des mésas ou inversement, une première partie ayant un premier taux de porosification et une deuxième partie, la deuxième partie ayant un deuxième taux de porosification supérieur au premier taux de porosification ou la deuxième partie étant évidée.

Selon un mode de réalisation particulier, la première partie correspond au flanc des mésas et la deuxième partie correspond au cœur des mésas.

Selon un mode de réalisation particulier, la deuxième partie correspond à l'emplacement initial du flanc des mésas et la première partie correspond au cœur des mésas.

Selon un mode de réalisation particulier, les mésas comprennent, depuis les faces latérales des mésas vers le centre des mésas ou inversement, une alternance de premières parties et de deuxièmes parties.

Selon un mode de réalisation particulier, le substrat de base comprend une couche support, une première couche de GaN non dopée, une deuxième couche de GaN dopée, une partie de la deuxième couche de GaN dopée se prolongeant dans les mésas,
le substrat de base pouvant en outre comprendre une ou plusieurs couches conductrices additionnelles, de préférence en GaN fortement dopée, disposées entre la première couche de GaN non dopée et la deuxième couche de GaN dopée.

Selon un mode de réalisation particulier, le premier taux de porosification est inférieur à 10% et/ou le deuxième taux de porosification est supérieur ou égal à 40%, de préférence compris entre 40 et 70 %.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et en coupe, une structure comprenant une mésa (Al,In,Ga)N/(Al,In,Ga)N ou InP/InP, avant porosification, selon un mode de réalisation particulier de l'invention ;
la figure 2 représente, de manière schématique et en coupe, une structure comprenant une mésa (Al,In,Ga)N ou InP, avant porosification, selon un autre mode de réalisation particulier de l'invention ;
la figure 3, la figure 4, la figure 5, la figure 6 et la figure 7 représentent, de manière schématique et en coupe, différentes structures comprenant des mésas (Al,In,Ga)N ou InP ou des mésas (Al,In,Ga)N/(Al,In,Ga)N ou InP/InP, après porosification, selon différents modes de réalisation particuliers de l'invention ;
la figure 8 est un graphique représentant différents phénomènes intervenant (pré-porosification (ou « pre-breakdown »), porosification et électropolissage) lors d'une étape d'anodisation, en fonction du taux de dopage et du potentiel appliqué, selon un mode de réalisation particulier de l'invention ;
la figure 9A et la figure 9B sont des clichés obtenus au microscope électronique à balayage d'une mésa (Al,In,Ga)N/(Al,In,Ga)N porosifiée, respectivement, en vue de côté et en coupe, selon un autre mode de réalisation particulier de l'invention ;
la figure 10 est un cliché obtenu au microscope électronique à balayage d'une mésa (Al,In,Ga)N porosifiée, vue en coupe, selon un autre mode de réalisation particulier de l'invention ;
la figure 11 et la figure 12 sont des clichés obtenus au microscope électronique à balayage de différentes mésas (Al,In,Ga)N/(Al,In,Ga)N porosifiées, en vue en coupe, selon différents modes de réalisation particulier de l'invention.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Par compris entre X et Y, on entend que les bornes X et Y sont inclues.

Le taux de porosité (ou de porosification) d'un matériau est le rapport entre le volume des pores (volume des vides) et le volume total du matériau.

Un taux de porosification est strictement supérieur à 0% et strictement inférieur à 100%.

Bien que cela ne soit aucunement limitatif, l'invention trouve particulièrement des applications dans le domaine des micro-écrans couleurs, et plus particulièrement pour la fabrication des pixels rouge vert bleu.

Cependant, elle pourrait être utilisée dans le domaine du photovoltaïque ou encore de l'électrolyse de l'eau (« water splitting ») puisque, d'une part, l'InGaN absorbe dans tout le spectre visible et que, d'autre part, ses bandes de valence et de conduction sont autour du domaine de stabilité de l'eau, condition thermodynamique nécessaire à la réaction de décomposition de l'eau. De plus, il présente une importante surface spécifique, ce qui est particulièrement avantageux.

L'invention peut également être intéressante pour la fabrication de LED ou de laser émettant à grande longueur d'onde.

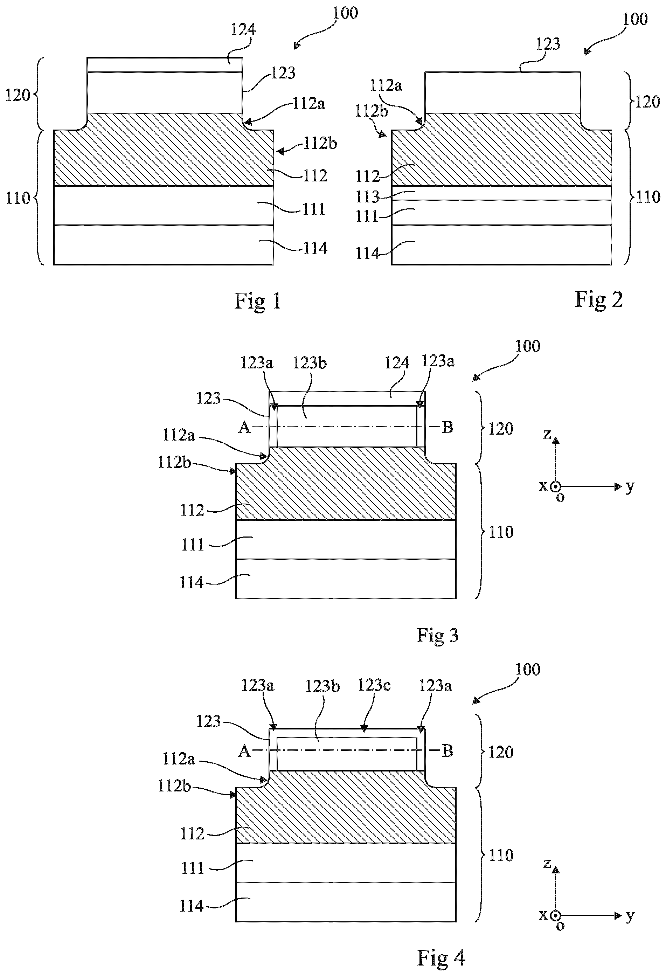

Le procédé de porosification qui va être décrit plus en détail par la suite peut être mis en œuvre sur des structures 100 ayant des mésas 120 (Al,In,Ga)N/(Al,In,Ga)N (figure 1) ou des mésas 120 (Al,In,Ga)N (figure 2).

Par (Al,In,Ga)N, on entend AlN, AlGaN, InGaN ou GaN. Par la suite, on fait plus particulièrement référence à du GaN poreux, mais avec un tel procédé, il est possible d'avoir, par exemple, de l'InGaN ou du AlGaN poreux. La couche dense en InGaN (en compression) ou la couche dense en AlGaN (en tension) va se relaxer grâce à une structure poreuse quelle que soit sa composition.

Par mésa (Al,In,Ga)N/(Al,In,Ga)N, on entend que les mésas comprennent une couche de (Al,In,Ga)N fortement dopée 123 à porosifier recouverte par une couche 124 de (Al,In,Ga)N non dopée ou faiblement dopée (figure 1). Selon cette configuration, la reprise d'épitaxie est réalisée sur la couche 124 non dopée ou faiblement dopée. De même, par mésa InP/InP, on entend que les mésas comprennent une couche de InP fortement dopée 123 à porosifier recouverte par une couche 124 de InP non dopée ou faiblement dopée.

Par mésa (Al,In,Ga)N, on entend que les mésas comprennent une couche de (Al,In,Ga)N fortement dopée 123 à porosifier. La couche de (Al,In,Ga)N fortement dopée 123 à porosifier n'est pas recouverte par une couche de (Al,In,Ga)N non dopée ou faiblement dopée. Selon cette configuration, la reprise d'épitaxie est réalisée directement sur la couche de (Al,In,Ga)N fortement dopée 123 porosifiée. De même, par mésa InP, on entend que les mésas comprennent une couche de InP fortement dopée 123 à porosifier. La couche de InP fortement dopée 123 à porosifier n'est pas recouverte par une couche de InP non dopée ou faiblement dopée.

Par la suite, le procédé et la structure vont être plus particulièrement décrits pour des mésas (Al, In, Ga) N/ (Al, In, Ga) N ou des mésas (Al, In, Ga) N, mais l'invention peut être réalisée sur des mésas InP/InP ou des mésas InP.

Le procédé de porosification comprend les étapes suivantes :
a) fournir une structure 100 comprenant un substrat de base 110 recouvert de mésas 120, les mésas 120 étant des mésas (Al,In,Ga)N/(Al,In,Ga)N (figure 1) ou des mésas (Al,In,Ga)N (figure 2),
b) relier électriquement la structure 100 et une contre-électrode à un générateur de tension ou de courant,
c) plonger la structure 100 et la contre-électrode dans une solution électrolytique,
d) porosifier les mésas 120 par voie électrochimique en réalisant une ou plusieurs fois le cycle formé des étapes i) et ii) suivantes :
   i) appliquer un premier potentiel pendant une première durée entre la structure 100 et la contre-électrode,
   ii) appliquer un deuxième potentiel pendant une deuxième durée entre la structure 100 et la contre-électrode.

La mise en œuvre d'une étape porosification en plusieurs étapes, avec différents potentiels, permet d'obtenir des mésas structurées présentant plusieurs parties différemment porosifiées, dans le plan xOy, autrement dit dans un parallèle à l'empilement formé par le substrat de base et la mésa (figures 2 à 7). Les parties différemment porosifiées se succèdent, pour chaque mésa, depuis les faces latérales de la mésa 120 vers le centre de la mésa 120.

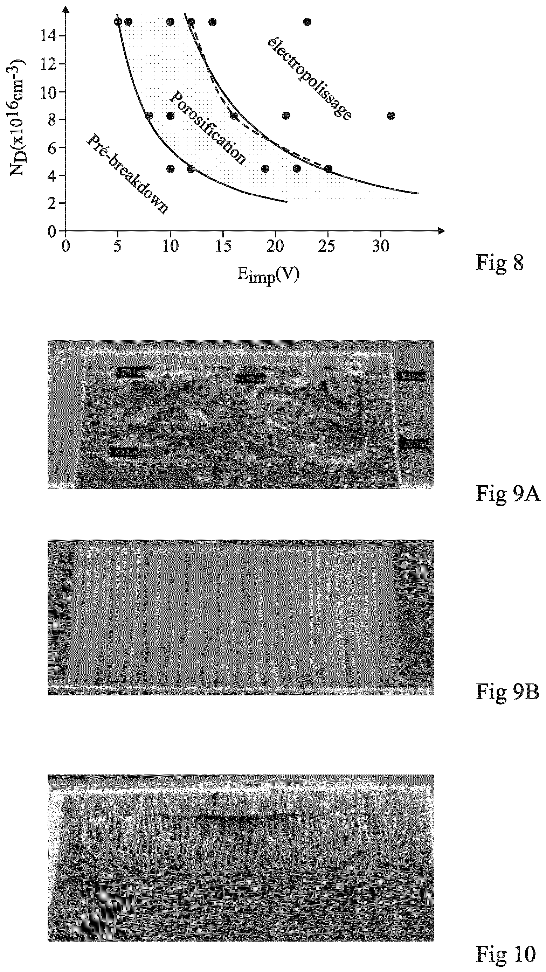

Il n'y a pas besoin d'avoir différents dopages dans la mésa pour moduler la porosité. La porosité est modulée en fonction des différents potentiels appliqués. En effet, à taux de dopage constant, en fonction du potentiel appliqué, des taux de porosité, tailles de pores et densités différents sont obtenus (voir « abaque » de la figure 8).

A faible potentiel, le taux de porosité et la taille des pores sont faibles. Il s'agit d'un régime de nucléation ('pre-breakdown'), conduisant à la création de canaux. Les canaux sont créés à partir :
- des flancs des mésas 120, lorsque les mésas comprennent une couche supérieure non dopée 124, ou
- des flancs et de la partie supérieure des mésas 120 (i.e. au niveau des parties suffisamment dopées et en contact avec la solution électrolytique) lorsque les mésas 120 ne sont pas recouvertes par la couche supérieure non dopée.

A plus fort potentiel, le régime de porosification est atteint : la porosification se propage dans les zones les plus conductrices (autrement dit, dans les parties de la mésa qui n'ont pas encore été impliquées dans les réactions électrochimiques, consommatrices de charges).

Plusieurs structures porosifiées peuvent être obtenues.

Selon une variante de réalisation, comme par exemple représenté sur la figure 3 ou sur la figure 4, la mésa 120 présente une première partie 123a porosifiée, ayant un premier taux de porosification, et une deuxième partie 123b porosifiée ayant un deuxième taux de porosification, le premier taux de porosification étant inférieur au deuxième taux de porosification. De préférence, les flancs de la mésa 120 correspondent à la première partie 123a. Autrement dit, le cœur 123b de la mésa est plus porosifié que les flancs 123a de la mésa 120. Ceci permet d'avoir moins de porosité sur la surface des flancs tout en conservant une forte porosité centrale. La porosité plus faible sur les flancs limite la rugosité de leur surface et impactera donc moins la reprise d'épitaxie, facilitant ainsi la mise en œuvre de l'ensemble des étapes technologiques nécessaires (un plus faible volume de solution chimique qui pénètre la structure poreuse, moins de relargage, une meilleure intégrité de la structure qui est plus adaptée à recevoir un dépôt conforme, etc).

De telles structures sont particulièrement avantageuses car elles permettent de :
- moduler la porosité qui joue un rôle fort sur l'incorporation d'In lors de la reprise d'épitaxier InGaN,
- conserver l'effet de compliance apporté par la forte porosité au centre de la mésa et permettre une incorporation d'In adaptée à l'émission des puits quantique en InGaN dans le rouge (typiquement supérieure à 620 nm).

Dans le cas où les mésas 120 sont des mésas (Al,In,Ga)N (i.e. dans le cas où la couche dopée 123 est en contact avec l'électrolyte), la partie supérieure 123c de la couche dopée 123 est également porosifiée selon un axe perpendiculaire à l'empilement mésa/substrat (figure 4). Le taux de porosification de la partie supérieure 123c de la mésa 120 correspond au taux de porosification des flancs des mésas 120.

Un avantage de cette structure est que l'épitaxie initiale est plus simple puisque mono-matériaux (dans ce cas la couche GaN ou InGaN nid n'est plus nécessaire).

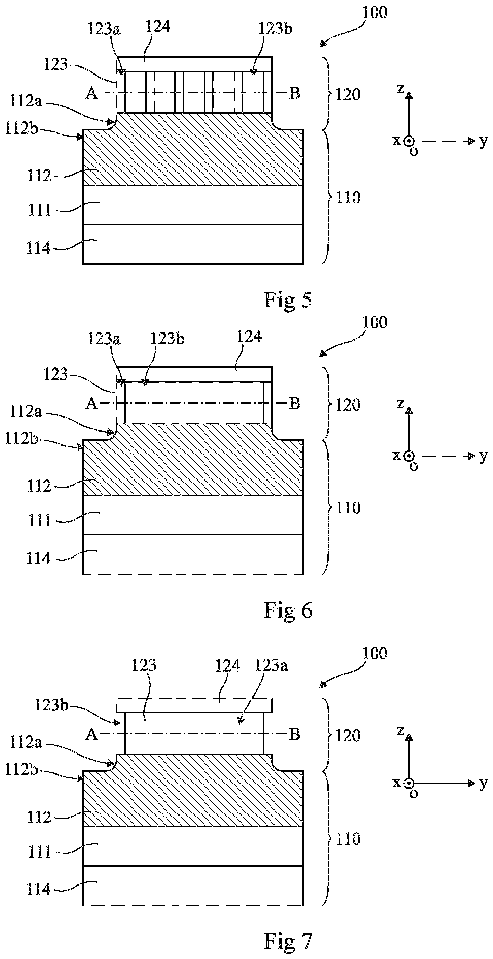

Selon une autre variante de réalisation, par exemple représentée sur les figures 6 et 7, la mésa 120 présente une première partie 123a porosifiée et une deuxième partie 123b évidée (i.e. dépourvue de matière).

La partie 123b évidée peut correspondre à la partie centrale de la mésa, la partie porosifiée 123a formant alors les flancs de la mésa. La mésa a une forme de 'tambour' (figure 6).

Autrement, comme représenté sur la figure 7, la partie 123b évidée peut correspondre à l'emplacement initial des flancs de la mésa 120 et la première partie porosifiée 123a au cœur de la mésa 120. Par exemple, pour obtenir une telle structure, le premier potentiel se situe dans la zone d'électropolissage pour graver les flancs et réduire la largeur de la structure mésa. Le deuxième potentiel appliqué est inférieur au premier potentiel pour porosifier le cœur des mésas.

Selon une autre variante de réalisation, comme, par exemple, représenté sur la figure 5, il est possible de former une structure ayant des mésas 120 présentant une alternance de premières parties 123a et de deuxièmes parties 123b lorsque le cycle d'étapes i) et ii) est répété plusieurs fois. Les deuxièmes parties 123b peuvent être fortement poreuses ou dépourvues de matière. Une telle structure 100 est intéressante pour les micro-écrans ('µ-displays') car les différentes porosités induisent des taux de relaxation variables de la couche supérieure. Une telle structure 100 peut aussi être intéressante pour d'autres applications photoniques.

Nous allons maintenant décrire plus en détail les différentes étapes du procédé.

La structure 100 fournie à l'étape a) comprend un substrat de base 110 recouvert de mésas 120.

Le substrat de base 110 comprend successivement (figures 1 et 2) :
- une couche support 114,
- éventuellement une couche tampon en (Al,Ga)N (non représentée), notamment dans le cas d'une couche support 114 en silicium,
- une première couche de GaN non dopée 111,
- éventuellement, une couche additionnelle de GaN fortement dopée 113,
- une deuxième couche de GaN dopée 112, une première partie 112a de la couche de GaN dopée 112 se prolongeant dans les mésas 120 et une deuxième partie 112b de la deuxième couche de GaN dopée faisant partie du substrat 110.

La deuxième couche de GaN dopée 112 peut être non intentionnellement dopée si la structure comprend la couche additionnelle de GaN fortement dopée 113.

La première partie 112b de la couche GaN dopée est une couche commune à toutes les mésas.

Chaque mésa 120 comprend successivement depuis la base : la deuxième partie 112a de la couche de GaN dopée 112, la troisième couche de GaN fortement dopée 123 et, le cas échéant, la quatrième couche de (Al,In,Ga)N non dopée ou faiblement dopée 124.

La structure 100 fournie à l'étape a) est, par exemple, obtenue en fournissant puis gravant localement un empilement comprenant successivement :
- une couche support 114 (aussi appelée substrat),
- éventuellement, une couche tampon en (Al,Ga)N, notamment dans le cas d'une couche support 114 en silicium ou en SiC,
- une première couche de nitrure de gallium GaN non dopée 111,
- éventuellement, une couche additionnelle de GaN fortement dopée 113,
- une deuxième couche de GaN 112 dopée (GaN n) ou non intentionnellement dopée (si la structure comprend la couche additionnelle de GaN fortement dopée 113),
- une troisième couche de GaN fortement dopée (GaN n+ ou GaN nn) 123, et
- le cas échéant, une quatrième couche en AlN, InGaN ou GaN (noté (Al,In,Ga)N) non intentionnellement dopée (nid) ou faiblement dopée 124.

De préférence, l'empilement est constitué des couches précédemment citées. Autrement dit, il ne comporte pas d'autres couches.

La structuration de l'empilement est, par exemple, réalisée par photolithographie.

Ainsi, on obtient une structure 100 comprenant un substrat de base 110 surmonté d'une pluralité de mésas 120 en (Al, In, Ga) N/ (Al, In, Ga) N.

Les mésas 120, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est de préférence réalisée avec un masque dur, par exemple en SiO₂. Après gravure des mésas, ce masque dur est retiré par un procédé chimique humide avant porosification. Il est également possible de retirer ce masque dur après porosification, en le dégageant uniquement, dans les zones servant à la polarisation électrochimique. Avantageusement, le masque est retiré avant l'étape de porosification.

De préférence, les faces latérales et les flancs (parties latérales) des mésas 120 sont perpendiculaires à cet empilement de couches.

La surface des mésas peut être circulaire, hexagonale, carrée ou rectangulaire.

La plus grande dimension de la surface des mésas 120 va de 500nm à 500µm. Par exemple, la plus grande dimension d'une surface circulaire est le diamètre.

L'épaisseur des mésas correspond à la dimension de la mésa perpendiculaire à l'empilement sous-jacent.

Les mésas 120 peuvent avoir un pas inférieur à 30 µm. L'espacement entre deux mésas 120 consécutives va de 50nm à 20µm.

Les mésas 120 peuvent avoir des dopages identiques ou différents. Plus le taux de dopage est élevé, et plus la porosification sera importante à potentiel fixe. La relaxation de la quatrième couche 124 de (Al,In,Ga)N dense dépend du taux de porosification des mésas. Ainsi, des quantités différentes d'indium pourront être intégrées lors de la ré-épitaxie d'InGaN sur la couche dense 124, grâce à la réduction du « compositionnal pulling effect » (i.e. du poussage des atomes d'In vers la surface, les empêchant de s'incorporer dans la couche). On obtiendra ainsi, après épitaxie de la structure LED complète, des mésas bleues, vertes et rouges (RGB) sur un même substrat, et en une seule étape de croissance, si l'écart entre les niveaux de relaxation des mésas est suffisant.

La couche support 114 est, par exemple, en saphir, en SiC ou en silicium. Elle pourrait être en GaN aussi ('GaN free standing').

La couche support 114 a, par exemple, une épaisseur allant de 250µm à 2mm. L'épaisseur dépend de la nature de la couche support 114 et de ses dimensions. Par exemple, pour une couche support en saphir de 2 pouces de diamètre, l'épaisseur peut être de 350 µm. Pour une couche support en saphir de 6 pouces de diamètre, l'épaisseur peut être de 1, 3mm. Pour une couche support en silicium de 200mm de diamètre, l'épaisseur peut être 1mm.

Dans le cas d'une couche support 114 en silicium, une couche tampon ('buffer') en (Al,Ga)N est, avantageusement, interposée entre la couche support 114 et la couche nid GaN 111.

La première couche 111 est une couche en GaN nid. C'est une couche non intentionnellement dopée (nid) pour ne pas être porosifiée. Par (In)GaN non intentionnellement dopée, on entend une concentration inférieure à 5^{e}17at/cm³ pour l'InGaN et 5^{e}17at/cm³ pour le GaN.

La première couche 111 en GaN nid a, par exemple, une épaisseur allant de 500nm à 5µm. Avantageusement, son épaisseur est entre 1 et 4 µm pour absorber les contraintes liées au désaccord de maille entre le GaN et le substrat.

Pour de l'InP, la couche 124 InP non dopée ou faiblement dopée (n-) a, par exemple, un dopage inférieur à 1^{e}17 at.cm⁻³ et la couche InP fortement dopée 123 (n+) a, par exemple, un dopage supérieur à 5^{e}18 at.cm⁻³.

Selon un mode de réalisation particulièrement avantageux, la structure 100 comprend la couche additionnelle de GaN fortement dopée 113 (uniquement représentée sur la figure 2 mais pouvant être présente dans toutes les structures) disposée entre la première couche de GaN non dopée 111 et la deuxième couche de GaN dopée 112. On a ainsi un tri-couche comprenant une couche fortement dopée de GaN recouverte par la deuxième couche dopée 112 et la troisième couche de GaN fortement dopée 123 à porosifier. La deuxième couche dopée 112 assure la protection de la couche fortement dopée additionnelle 113 sous-jacente et la prise de contact, lors de la porosification. Ainsi, la couche additionnelle 113 n'est pas en contact avec la solution.

La couche additionnelle 113 fortement dopée assure la conduction latérale des charges dans la structure. Par exemple, le taux de dopage de la couche additionnelle de GaN fortement dopé est compris entre 5.10¹⁸at/cm³ et 2.10¹⁹at/cm³, de préférence entre 5.10¹⁸at/cm³ et 1,5.10¹⁹at/cm³, encore plus préférentiellement entre 8.10¹⁸at/cm³ et 1.10¹⁹at/cm³. Avantageusement, cette couche est épaisse (typiquement entre 0,5 µm et 5µm et de préférence entre 1 et 2µm). Des épaisseurs les plus élevées pourront être obtenues sur saphir. On obtient ainsi une couche enterrée très conductrice grâce à un fort taux de dopage et une épaisseur de couche importante. Le couple épaisseur dopage sera adapté pour avoir une conduction latérale suffisante. Lors de l'étape d), la conduction se fait *via* cette couche additionnelle enterrée très dopée. Comme elle est très conductrice, elle limite les effets bord / centre.

Les charges passent à travers la deuxième couche dopée 112 puis se retrouvent sur la couche additionnelle 113 très dopée qui joue alors le rôle d'autoroute de conduction et alimente toutes les mésas présentes sur le substrat. Lors de l'étape d), la deuxième couche dopée 112 protège la couche additionnelle fortement dopée 113 de la porosification. Ainsi, chaque mésa 120 est dans la même configuration électrique pour être porosifiée de façon uniforme quelle que soit la taille et la position de la mésa sur la plaque (bord ou centre).

La deuxième couche 112 peut être une couche en GaN dopée ou faiblement dopée, selon l'architecture de la structure. Par GaN dopée, on entend une concentration supérieure à 1.10¹⁷ at/cm³, de préférence supérieure à 5.10¹⁷ at/cm³, de préférence entre 5.10¹⁷ at/cm³ et 2.10¹⁸ at/cm³. Comme indiqué précédemment, dans le cas d'un tricouche (i.e. si la couche 113 est présente), la couche 112 peut être en GaN dopée ou en nid-GaN.

La deuxième couche 112 en GaN a, par exemple, une épaisseur allant de 200nm à 1µm, préférentiellement entre 400 et 700nm. Elle doit être suffisamment électriquement conductrice pour pouvoir réaliser une reprise de contact sur cette couche lors de l'étape d'anodisation électrochimique. L'épaisseur minimale varie en fonction du taux de dopage. Cette couche électriquement conductrice est électriquement connectée au générateur de tension ou de courant.

La troisième couche 123 est une couche de GaN fortement dopée. Par GaN fortement dopée, on entend une concentration supérieure à 5.10¹⁸ at/cm³, de préférence supérieure à 8.10¹⁸ at/cm³, voire supérieure à 10¹⁹ at/cm³. Elle a, par exemple, un dopage dix fois plus élevé que la deuxième couche 112. Elle a une épaisseur, par exemple, comprise entre 200nm et 2 µm. De préférence de 500 nm à 1µm.

La quatrième couche 124 est une couche (Al,In,Ga)N non intentionnellement dopée ou faiblement dopée. Par (Al,In,Ga)N faiblement dopé, on entend un dopage entre 5.10¹⁷ at.cm³ et 1.10¹⁸ at. cm³. Par non dopée, on entend un taux de dopage inférieur à 5^{e}17at/cm³ voire inférieur à 1^{e}17at/cm³.

Il peut s'agir d'une couche en AlN, AlGaN, InGaN ou GaN. Elle a par exemple une épaisseur entre 10nm et 200nm, de préférence entre 50 et 200nm. Le dopage est suffisamment faible de manière à ce que cette couche soit électriquement isolante. Elle n'est pas porosifiée lors de l'étape d).

Cette couche 124 n'est pas ou peu impactée par la porosification et sert de germe pour une reprise de croissance. Cette couche 124 est continue pour assurer la qualité de la couche répitaxiée, d'une couche d' (In,Ga)N par exemple, sur la structure.

Les dopages des différentes couches précitées seront choisis en fonction de la tension appliquée lors de la porosification.

En particulier, ils seront choisis à partir d'un « abaque » tel que celui de la figure 8. Cet « abaque » permet de définir les taux de dopage respectifs pour qu'à potentiel donné, il y ait une sélectivité entre la zone fortement dopée et la zone faiblement dopée. Pour un potentiel donné, le taux de dopage de la deuxième couche 112 doit se situer dans la région 'pre-breakdown' pour que la deuxième couche 112 ne soit pas porosifiée lors de l'étape d). Le taux de dopage de la troisième couche 123 doit se situer dans la région 'porosification' pour que la troisième 123 soit porosifiée ou dans la zone 'électropolissage' pour que la troisième couche 123 soit gravée.

Par la suite, on décrit un dopage de type n, mais il pourrait s'agir d'un dopage de type p. Les conditions électrochimiques (par exemple le potentiel) seront choisies pour un tel dopage.

A titre illustratif et non limitatif, selon une variante de réalisation, la structure 100 à porosifier peut comprendre :
- un substrat de base 110 comprenant successivement : une couche support 114 en saphir ou en silicium, éventuellement une couche tampon en (Al,Ga)N, une première couche 111 de GaN non dopée de 4µm, une première partie 112a de la deuxième couche 112 de GaN dopée de 500nm (1.10¹⁸ at/cm³),
- des mésas 120 (Al,In,Ga)N/(Al,In,Ga)N comprenant successivement : une deuxième partie 112b de la deuxième couche 112 de GaN dopée de 100nm (1.10¹⁸ at/cm³), une troisième couche 123 de GaN fortement dopée de 800 nm (1.10¹⁹ at/cm³), et, le cas échéant, une couche de nid (Al,In,Ga)N de 100nm.

Une couche additionnelle 113 de GaN fortement dopée de 2µm (1.10¹⁹ at/cm³) peut être positionnée entre la première couche 111 de GaN non dopée et la première partie 112a de la deuxième couche 112 de GaN dopée.

Lors de l'étape b), la structure 100 et une contre-électrode (CE) sont électriquement reliées à un générateur de tension ou de courant. Le dispositif joue le rôle d'électrode de travail (WE). Par la suite, on le dénommera générateur de tension, mais il pourrait s'agir d'un générateur de courant permettant d'appliquer un courant entre le dispositif et la contre-électrode.

La prise de contact est réalisée sur la structure 100.

En particulier, la prise de contact peut être réalisée sur le substrat de base 110, notamment sur la deuxième couche de GaN dopée 112. De préférence, la prise de contact peut être faite sur le fond des mésas 120, au niveau de la deuxième partie 112b de la deuxième couche 112, ce qui permet d'utiliser l'étape de gravure pour réaliser également les prises de contact.

La zone de reprise de contact peut également être surmontée d'une couche métallique afin d'améliorer le contact pour la polarisation électrochimique. Ce contact pourra être retiré après la porosification et avant la reprise d'épitaxie.

La contre-électrode est en un matériau électriquement conducteur, comme par exemple un métal de grande surface développée et inerte à la chimie de l'électrolyte tel qu'un grillage en platine.

Lors de l'étape c), les électrodes sont plongées dans un électrolyte, aussi appelé bain électrolytique ou solution électrolytique. L'électrolyte peut être acide ou basique. L'électrolyte est, par exemple, de l'acide oxalique, du KOH, HF, HNO₃, NaNO₃ ou H₂SO₄. Il peut également s'agir d'un de leurs mélanges, par exemple un mélange d'acide oxalique et de NaNO₃ pour favoriser la cinétique.

Lors de l'étape d), les mésas sont porosifiées.

Le premier potentiel E1 est différent du deuxième potentiel E2. Le premier potentiel E1 est, de préférence, inférieur au deuxième potentiel E2.

La modulation de potentiel au cours de l'anodisation permet, dans un premier temps, de porosifier très faiblement les flancs de la mésa et ensuite de porosifier davantage le centre de la mésa, voire de le graver. Ainsi, la première étape à faible potentiel (E1) permet la création de canaux. Ces canaux conduisent alors l'électrolyte vers le centre de la mésa qui sous l'effet d'un second potentiel (E2 avec E2>E1) se porosifie plus largement que les flancs, voire est électropoli. On obtient des mésas ayant une partie centrale très poreuse ou dépourvue de matière et des flancs peu poreux.

Lors de l'itération des étapes i) et ii), il serait également possible d'utiliser des potentiels et/ou durées différentes de ceux utilisés lors du premier cycle d'étapes i) et ii). De préférence, les mêmes potentiels sont utilisés.

En fonction de la largeur des mésas, il est possible d'adapter le nombre d'itérations, les potentiels et les temps d'application des potentiels. Il est possible de moduler le nombre de premières parties 123a (peu poreuses) et de deuxièmes parties 123b (fortement poreuses ou évidées) ainsi que leurs largeurs.

Les potentiels appliqués peuvent être compris entre 1 et 50V. De préférence, ils sont compris entre 3 et 20V.

Par exemple, le premier potentiel est compris entre 3 V et 12 V et/ou le deuxième potentiel est compris entre 5 et 20 V.

Sur saphir, le premier potentiel est, de préférence, compris entre 3,5 et 4,5 V et/ou le deuxième potentiel est compris entre 7 et 10 V.

Sur silicium, le premier potentiel est, de préférence, compris entre 7 et 10 V et/ou le deuxième potentiel est, de préférence, compris entre 14 et 17 V.

Le potentiel est choisi en fonction des taux de dopage des différentes couches, afin d'obtenir la sélectivité recherchée. Il est appliqué par exemple, pendant une durée allant de quelques secondes à plusieurs heures.

La porosification est complète lorsqu'il n'y a plus de courant à potentiel imposé. A ce moment-là, toute la structure dopée est porosifiée et la réaction électrochimique s'arrête.

Il est également possible de réaliser une porosification incomplète et de conserver un cœur non porosifié et non gravé. Le cœur non porosifié est entouré, de part et d'autre, successivement par la deuxième partie formant une zone intermédiaire fortement poreuse puis par la première partie formant des flancs peu poreux.

L'étape d'anodisation électrochimique peut être activée par une irradiation à la longueur d'onde correspondant au gap du matériau (par exemple, UVA pour le GaN, UVB et UVC pour l'AlGAN en fonction du taux de Al).

Avantageusement, à l'issue de l'étape de porosification tout le volume de la troisième couche de GaN fortement dopé 123 est porosifié.

La première partie 123a est faiblement poreuse. Le premier taux de porosification est, de préférence, inférieur à 10%. Il est, par exemple, compris entre 2 et 10%.

La deuxième partie 123b est évidée ou fortement poreuse. Le deuxième taux de porosification est, de préférence, d'au moins 40%. Il est, par exemple, compris entre 40% et 70%.

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

Les porosifications obtenues (taux de porosité, aussi appelé taux de porosification, et taille des pores) dépendent du dopage de la couche et des paramètres du procédé (tensions appliquées, durées, nature et concentration de l'électrolyte, post-traitement chimique ou recuit). La variation de la porosification permet de contrôler le taux d'incorporation / ségrégation. La porosification, et en particulier, la taille des pores et leur morphologie, pourra varier ultérieurement, lors de la reprise d'épitaxie en fonction de la température appliquée.

Le procédé peut également comprendre une étape au cours de laquelle la partie 123b fortement poreuse est gravée par une solution, notamment une solution alcaline, de préférence KOH ou de l'hydroxyde de tétraméthylammonium (TMAH).

Avantageusement, le procédé comprend une étape e) ultérieure au cours de laquelle on réalise une épitaxie sur les mésas 120, moyennant quoi on obtient une couche épitaxiée au moins partiellement relaxée, et de préférence totalement relaxée.

Le pourcentage de relaxation correspond à :$Δ a / a = \left({a}_{c 2}{- a}_{c 1}\right) {/ a}_{c 1}$
avec a_{c1}, le paramètre de maille de la couche de départ sur laquelle on reprend l'épitaxie (c'est-à-dire le paramètre de maille de la couche 124), et
a_{c2} le paramètre de maille de la couche relaxée,
La couche est relaxée à 100% si ac₂ correspond au paramètre de maille du matériau massif, de même composition que la couche réépitaxiée.

Lorsque a_{c1}=a_{c2} le couche est dite contrainte.

Par partiellement relaxée, on entend un pourcentage de relaxation supérieur à 50%.

La reprise d'épitaxie peut servir, par exemple, pour former des LED ré-épitaxiées.

La reprise d'épitaxie peut être réalisée sur la quatrième couche 124 nid ou faiblement dopée des mésas 120. Comme cette couche n'est pas porosifiée lors de l'étape d'anodisation électrochimique, elle reste continue et dense. La reprise d'épitaxie est ainsi facilitée et la couche épitaxiée présente une meilleure tenue. La création de défauts liées à la coalescence des pores est évitée.

La reprise d'épitaxie peut être également réalisée sur la partie supérieure 123c de la couche dopée porosifiée 123 des mésas. Comme cette couche est faiblement porosifiée, la reprise d'épitaxie peut être facilement réalisée.

La couche épitaxiée lors de cette étape e) est, avantageusement, en nitrure de gallium ou en nitrure d'indium et de gallium.

### Exemples illustratifs et non limitatifs de différents modes de réalisation

Plusieurs structures ont été réalisées.

### 1^{ère} structure

La première structure à porosifier est une structure telle que celle représentée sur la figure 1. Elle présente des mésas (Al,In,Ga)N/(Al,In,Ga)N, et plus particulièrement à des mésas InGaN/GaN ou GaN/GaN.

La première étape à faible potentiel (E1 = 4,5 V pendant 300s) permet la création de canaux au niveau des flancs qui deviennent moins conducteurs. Les canaux servant à conduire l'électrolyte vers le centre de la mésa lorsque le second potentiel est appliqué. Sous l'effet du second potentiel E2 plus fort que le premier potentiel (E2 = 11 V pendant 250s), le centre de la mésa se porosifie plus largement que les flancs. La réaction de porosification a lieu à l'interface électrolyte / zone très conductrice ou très dopée, c'est-à-dire au niveau de la zone centrale de la mésa.

La modulation de potentiel au cours de l'anodisation permet de porosifier très faiblement les flancs de la mésa et ensuite de porosifier davantage le centre de la mésa (figures 9A et 9B).

### 2^{ème} structure

La deuxième structure à porosifier correspond à une structure telle que celle représentée sur la figure 2. La structure comprend des mésas (Al,In,Ga)N, et plus particulièrement des mésas GaN dopé Si. Dans cette structure, il n'y a pas de couche nid recouvrant les mésas.

Comme dans le cas de la première structure, deux potentiels différents sont appliqués. Le premier potentiel E1 = 3V est appliqué pendant 130s et le deuxième potentiel E2 est appliqué pendant 100s. L'application de deux potentiels différents permet de former sur la partie supérieure ainsi que sur les flancs des mésas une couche très peu poreuse. La taille des pores est très faible (typiquement inférieure à 10nm) et compatible avec une reprise d'épitaxie GaN sans défaut (puisque l'épitaxie GaN latérale est forte). Le procédé multi potentiel permet ici, à partir d'une mésa en GaN dopé n, d'obtenir une mésa à structure « cœur/coquille » ayant un cœur très poreux et une enveloppe très peu poreuse (figure 10).

L'épaisseur de l'enveloppe peu poreuse dépend du temps d'application du premier potentiel E1 < E2. Dans le cas de la structure n°2, 130s à E1 produit une enveloppe de 200 à 250 nm. Ce temps peut être réduit et il est possible de réaliser des enveloppes plus fines de l'ordre de 50 à 100nm.

Ce procédé permet une porosification verticale et homogène sur toute la mésa hormis l'enveloppe peu poreuse. Le cœur présente une porosité d'au moins 40% avec une morphologie dendritique.

Une telle relaxation verticale est favorable à la relaxation. Elle peut améliorer la relaxation des couches supérieures épitaxiées qu'elle soit en InGaN pour l'émission rouge ou en AlGaN pour les applications UV.

### 3^{ème} structure

La troisième structure à porosifier correspond à une structure telle que celle représentée sur la figure 1. La structure présente des mésas (Al,In,Ga)N/(Al,In,Ga)N, et plus particulièrement à des mésas GaN/GaN.

Deux potentiels sont appliqués à la structure. Le potentiel E2 est supérieur au potentiel E1. Le potentiel E2 se trouve dans la zone d'électro-polissage du matériau. Ainsi, le centre de la mésa n'est pas porosifié mais gravé. Une étape additionnelle de gravure chimique, notamment une attaque chimique alcaline (par exemple TMAH ou KOH) peut être utilisée pour graver la partie de matériau pouvant éventuellement rester au centre de la mésa et former ainsi une cavité.

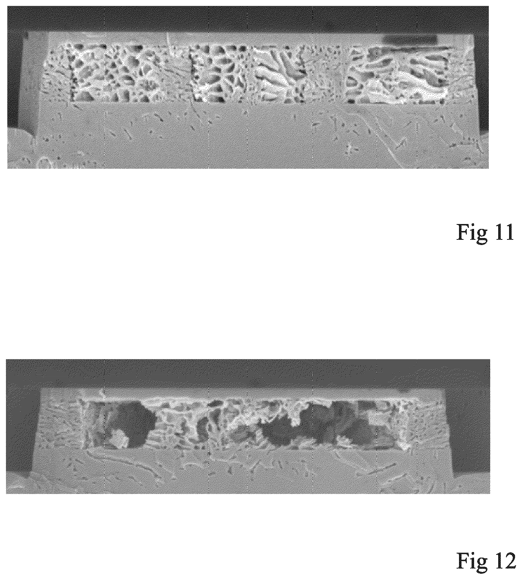

On obtient une membrane en InGaN ou GaN (mais il pourrait aussi s'agir d'une membrane en AlGaN) d'épaisseur variant entre 50nm et 200nm suspendue au-dessus d'une cavité avec des murs légèrement poreux en GaN de dimension variant entre 1µm et quelques µm, 3µm par exemple (figure 11).

La relaxation des contraintes sur cette couche GaN ou InGaN est maximale puisque la couche sur laquelle est réalisée la reprise d'épitaxie est désolidarisée de son substrat de croissance qui imposait son paramètre de maille. Ce nouveau type de structure (sorte de tambour) est particulièrement intéressant pour des dispositifs photoniques mais aussi des dispositifs de type MEMS.

### 4^{ème} structure

La quatrième structure à porosifier correspond à une structure telle que celle représentée sur la figure 1. La structure présente des mésas (Al,In,Ga)N/(Al,In,Ga)N, et plus particulièrement des mésas GaN/GaN.

Dans cet exemple, le premier potentiel E1 est appliqué pendant 200s et le deuxième potentiel E2 est appliqué pendant 120s. Le cycle d'application des potentiels E1 et E2 est répété une fois. La structure obtenue est représentée sur la figure 12.

En fonction de la largeur de la mésa, il est possible d'adapter le nombre d'itérations et le temps d'application des potentiels pour moduler le nombre d'alternance de zones peu poreuses et de zones poreuses ainsi que leur largeur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier, l'invention étant définie par les revendications attenantes.

Enfin, la mise en œuvre pratique des modes de réalisation et variantes décrits est à la portée de la personne du métier à partir des indications fonctionnelles données ci-dessus.

## Revendications

1. Procédé de porosification d'une structure (100) comprenant un substrat de base (110) recouvert de mésas (120), les mésas (120) étant des mésas (Al,In,Ga)N ou InP ou des mésas (Al,In,Ga)N/(Al,In,Ga)N ou InP/InP, les mésas (120) étant porosifiées par voie électrochimique selon le cycle d'étapes suivantes :
i) appliquer un premier potentiel pendant une première durée,
ii) appliquer un deuxième potentiel pendant une deuxième durée,
moyennant quoi on obtient des mésas (120) porosifiées comprenant, depuis les faces latérales des mésas (120) vers le centre des mésas (120) ou inversement, une première partie (123a) ayant un premier taux de porosification et une deuxième partie (123b), la deuxième partie (123b) ayant un deuxième taux de porosification supérieur au premier taux de porosification ou la deuxième partie (123b) étant évidée.

2. Procédé selon la revendication 1, dans lequel le premier potentiel est inférieur au deuxième potentiel.

3. Procédé selon l'une des revendications 1 et 2, dans lequel le premier potentiel est compris entre 3 V et 12 V et/ou dans lequel le deuxième potentiel est compris entre 5 et 20 V.

4. Procédé selon l'une quelconque des revendications précédentes, dans lequel l'étape i) ou le cycle d'étapes i) et ii) est répété au moins une fois de manière à former une alternance de premières parties (123a) et de deuxièmes parties (123b).

5. Structure (100) comprenant un substrat de base (110) recouvert de mésas (120) porosifiées, les mésas (120) porosifiées étant des mésas (Al,In,Ga)N ou InP ou des mésas (Al,In,Ga)N/(Al,In,Ga)N ou InP/InP, **caractérisée en ce que**
les mésas (120) comprennent, depuis les faces latérales des mésas (120) vers le centre des mésas (120) ou inversement, une première partie (123a) ayant un premier taux de porosification et une deuxième partie (123b), la deuxième partie (123b) ayant un deuxième taux de porosification supérieur au premier taux de porosification ou la deuxième partie (123b) étant évidée,
la première partie (123a) correspondant au flanc des mésas (120) et la deuxième partie (123b) correspond au cœur des mésas (120), ou
la deuxième partie (123b) correspondant à l'emplacement initial du flanc des mésas et la première partie (123a) correspondant au cœur des mésas, la deuxième partie (123b) ayant un deuxième taux de porosification supérieur au premier taux de porosification, ou
les mésas (120) comprenant, depuis les faces latérales des mésas (120) vers le centre des mésas (120) ou inversement, une alternance de premières parties (123a) et de deuxièmes parties (123b).

6. Structure selon la revendication 5, dans laquelle la première partie (123a) correspond au flanc des mésas (120) et la deuxième partie (123b) correspond au cœur des mésas (120).

7. Structure selon la revendication 5, dans laquelle la deuxième partie (123b) correspond à l'emplacement initial du flanc des mésas et la première partie (123a) correspond au cœur des mésas.

8. Structure selon la revendication 5, dans laquelle les mésas (120) comprennent, depuis les faces latérales des mésas (120) vers le centre des mésas (120) ou inversement, une alternance de premières parties (123a) et de deuxièmes parties (123b).

9. Structure (100) selon l'une des revendications 5 à 8, dans laquelle le substrat de base (110) comprend une couche support (114), une première couche de GaN non dopée (111), une deuxième couche de GaN dopée (112),
une partie (112a) de la deuxième couche de GaN dopée (112) se prolongeant dans les mésas (120),
le substrat de base (110) pouvant en outre comprendre une ou plusieurs couches conductrices additionnelles, de préférence en GaN fortement dopée, disposées entre la première couche de GaN non dopée (111) et la deuxième couche de GaN dopée (112).

10. Structure selon l'une quelconque des revendications 5 à 9, dans lequel le premier taux de porosification est inférieur à 10% et/ou dans lequel le deuxième taux de porosification est supérieur ou égal à 40%, de préférence compris entre 40 et 70 %.

## Patentansprüche

1. Ein Verfahren zum Porosifizieren einer Struktur (100), die ein Basissubstrat (110) aufweist, das mit Mesas (120) bedeckt ist, wobei die Mesas (120) (Al, In, Ga)N- oder InP-Mesas oder (Al, In, Ga)N/(Al, In, Ga)N- oder InP/InP-Mesas sind, wobei die Mesas (120) gemäß dem folgenden Zyklus von Schritten elektrochemisch porosifiziert werden:
i) Anlegen eines ersten Potentials für eine erste Dauer,
ii) Anlegen eines zweiten Potentials für eine zweite Dauer,
wodurch porosifizierte Mesas (120) erhalten werden, die von den Seitenflächen der Mesas (120) in Richtung der Mitte der Mesas (120) oder umgekehrt einen ersten Abschnitt (123a) mit einem ersten Porosifizierungsgrad und einen zweiten Abschnitt (123b) aufweisen, wobei der zweite Abschnitt (123b) einen zweiten Porosifizierungsgrad aufweist, der höher als der erste Porosifizierungsgrad ist, oder wobei der zweite Abschnitt (123b) ausgehöhlt ist.

2. Das Verfahren nach Anspruch 1, wobei das erste Potential niedriger als das zweite Potential ist.

3. Das Verfahren nach einem der Ansprüche 1 und 2, wobei das erste Potential zwischen 3 V und 12 V liegt und/oder wobei das zweite Potential zwischen 5 V und 20 V liegt.

4. Ein Verfahren nach einem der vorhergehenden Ansprüche, wobei Schritt i) oder der Zyklus der Schritte i) und ii) wenigstens einmal wiederholt wird, um eine Abfolge von ersten Abschnitten (123a) und zweiten Abschnitten (123b) auszubilden.

5. Eine Struktur (100), die ein Basissubstrat (110) aufweist, das mit porosifizierten Mesas (120) bedeckt ist, wobei die porosifizierten Mesas (120) (Al, In, Ga)N- oder InP-Mesas oder (Al, In, Ga)N/(Al, In, Ga)N- oder InP/InP-Mesas sind, wobei die Mesas (120) von den Seitenflächen der Mesas (120) in Richtung der Mitte der Mesas (120) oder umgekehrt einen ersten Abschnitt (123a) mit einem ersten Porosifizierungsgrad und einen zweiten Abschnitt (123b) aufweisen, wobei der zweite Abschnitt (123b) einen zweiten Porosifizierungsgrad aufweist, der höher als der erste Porosifizierungsgrad ist, oder wobei der zweite Abschnitt (123b) ausgehöhlt ist,
wobei der erste Abschnitt (123a) der Flanke der Mesas (120) entspricht und der zweite Abschnitt (123b) dem Kern der Mesas (120) entspricht, oder
wobei der zweite Abschnitt (123b) der ursprünglichen Position der Flanke der Mesas entspricht und der erste Abschnitt (123a) dem Kern der Mesas entspricht, wobei der zweite Abschnitt (123b) einen zweiten Porosifizierungsgrad aufweist, der größer als der erste Porosifizierungsgrad ist, oder
wobei die Mesas (120) von den Seitenflächen der Mesas (120) in Richtung der Mitte der Mesas (120) oder umgekehrt eine Abfolge von ersten Abschnitten (123a) und zweiten Abschnitten (123b) aufweisen.

6. Die Struktur nach Anspruch 5, wobei der erste Abschnitt (123a) der Flanke der Mesas (120) entspricht und der zweite Abschnitt (123b) dem Kern der Mesas (120) entspricht.

7. Die Struktur nach Anspruch 5, wobei der zweite Abschnitt (123b) der Flanke der Mesas entspricht und der erste Abschnitt (123a) dem Kern der Mesas entspricht.

8. Die Struktur nach Anspruch 5, wobei die Mesas (120) von den Seitenflächen der Mesas (120) in Richtung der Mitte der Mesas (120) oder umgekehrt eine Abfolge von ersten Abschnitten (123a) und zweiten Abschnitten (123b) aufweisen.

9. Die Struktur (100) nach einem der Ansprüche 5 bis 8, wobei das Basissubstrat (110) eine Trägerschicht (114), eine erste undotierte GaN-Schicht (111) und eine zweite dotierte GaN-Schicht (112) aufweist,
wobei sich ein Abschnitt (112a) der zweiten dotierten GaN-Schicht (112) in die Mesas (120) erstreckt,
wobei das Basissubstrat (110) ferner eine oder mehrere zusätzliche leitfähige Schichten, vorzugsweise aus hochdotiertem GaN, aufweisen kann, die zwischen der ersten undotierten GaN-Schicht (111) und der zweiten dotierten GaN-Schicht (112) angeordnet sind.

10. Die Struktur nach einem der Ansprüche 5 bis 9, wobei der erste Porosifizierungsgrad weniger als 10 % beträgt und/oder wobei der zweite Porosifizierungsgrad größer oder gleich 40 %, vorzugsweise zwischen 40 % und 70 %, ist.

## Claims

1. Process for porosifying a structure (100) comprising a base substrate (110) covered with mesas (120), the mesas (120) being (Al,In,Ga)N or InP mesas or (Al,In,Ga)N/(Al,In,Ga)N or InP/InP mesas, the mesas (120) being electrochemically porosified according to the following cycle of steps:
i) applying a first potential for a first duration,
ii) applying a second potential for a second duration,
whereby porosified mesas (120) are obtained comprising, from the side faces of the mesas (120) towards the center of the mesas (120) or vice versa, a first portion (123a) having a first porosification ratio and a second portion (123b), the second portion (123b) having a second porosification ratio higher than the first porosification ratio or the second portion (123b) being hollowed out.

2. Process according to claim 1, in which the first potential is lower than the second potential.

3. Process according to one of claims 1 and 2, wherein the first potential is between 3 V and 12 V and/or wherein the second potential is between 5 and 20 V.

4. A process according to any of the preceding claims, in which step i) or the cycle of steps i) and ii) is repeated at least once so as to form an alternation of first portions (123a) and second portions (123b).

5. Structure (100) comprising a base substrate (110) covered with porosified mesas (120), the porosified mesas (120) being (Al,In,Ga)N or InP mesas or (Al,In,Ga)N/(Al,In,Ga)N or InP/InP mesas,
wherein the mesas (120) comprise, from the side faces of the mesas (120) towards the center of the mesas (120) or vice versa, a first portion (123a) having a first porosification ratio and a second portion (123b), the second portion (123b) having a second porosification ratio higher than the first porosification ratio or the second portion (123b) being hollowed out,
the first portion (123a) corresponding to the flank of the mesas (120) and the second portion (123b) corresponding to the core of the mesas (120), or
the second portion (123b) corresponding to the initial location of the flank of the mesas and the first portion (123a) corresponding to the core of the mesas, the second portion (123b) having a second porosification ratio greater than the first porosification ratio, or
the mesas (120) comprising, from the side faces of the mesas (120) towards the center of the mesas (120) or vice versa, an alternation of first portions (123a) and second portions (123b).

6. Structure according to claim 5, in which the first portion (123a) corresponds to the flank of the mesas (120) and the second portion (123b) corresponds to the core of the mesas (120).

7. Structure according to claim 5, in which the second portion (123b) corresponds to the flank of the mesas and the first portion (123a) corresponds to the core of the mesas.

8. Structure according to claim 5, in which the mesas (120) comprise, from the side faces of the mesas (120) towards the center of the mesas (120) or vice versa, an alternation of first portions (123a) and second portions (123b).

9. Structure (100) according to one of claims 5 to 8, wherein the base substrate (110) comprises a support layer (114), a first undoped GaN layer (111), a second doped GaN layer (112),
a portion (112a) of the second doped GaN layer (112) extending into the mesas (120),
the base substrate (110) may further comprise one or more additional conductive layers, preferably of highly doped GaN, arranged between the first undoped GaN layer (111) and the second doped GaN layer (112).

10. Structure according to any one of claims 5 to 9, wherein the first porosification ratio is less than 10% and/or wherein the second porosification ratio is greater than or equal to 40%, preferably between 40 and 70%.
